# EUROPEAN PATENT SPECIFICATION

(11) **EP 2 417 283 B1**
(45) Date of publication and mention of the grant of the patent: **30.07.2014**
(21) Application number: 10710049.7
(22) Date of filing: 25.03.2010
(51) Int. Cl.: C25D 3/38, C23C 18/31, C23C 18/32, H01L 21/288, H05K 3/18, H05K 3/24, C25D 3/58, C25D 7/12, H05K 3/42, H01L 21/768

(54) **COMPOSITION FOR METAL PLATING COMPRISING SUPPRESSING AGENT FOR VOID FREE SUBMICRON FEATURE FILLING**
ZUSAMMENSETZUNG ZUR METALLABSCHEIDUNG MIT UNTERDRÜCKUNGSMITTEL ZUR HOHLRAUMFREIEN FÜLLUNG VON SUBMIKRON-STRUKTURMERKMALEN
COMPOSITION DE REVÊTEMENT MÉTALLIQUE COMPRENANT UN AGENT SUPPRESSEUR POUR LE REMPLISSAGE DE FORME SUMICRONIQUE SANS LACUNE

(30) Priority: 07.04.2009 EP 09005106; 30.10.2009 US 256333 P
(43) Date of publication of application: 15.02.2012
(73) Proprietor: BASF SE, 67056 Ludwigshafen (DE)
(72) Inventor: RÖGER-GÖPFERT, Cornelia, 68723 Schwetzingen (DE); RAETHER, Roman Benedikt, 67346 Speyer (DE); EMNET, Charlotte, 70597 Stuttgart (DE); HAAG, Alexandra, 91334 Hemhofen (DE); MAYER, Dieter, 64297 Darmstadt (DE)
(86) International application number: PCT/EP2010/053881
(87) International publication number: WO 2010/115717

(56) References cited:
- WO-A2-2006/053242
- US-A1- 2006 213 780

## Description

Filling of small features, such as vias and trenches, by copper electroplating is an essential part of the semiconductor manufacture process. It is well known, that the presence of organic substances as additives in the electroplating bath can be crucial in achieving a uniform metal deposit on a substrate surface and in avoiding defects, such as voids and seams, within the copper lines.

One class of additives are the so-called suppressors or suppressing agents. Suppressors are used to provide a substantially bottom-up filling of small features like vias or trenches. The smaller the features are the more sophisticated the additives have to be to avoid voids and seams. In literature, a variety of different suppressing compounds have been described. The mostly used class of suppressors are polyether compounds like polyglycols or polyalkylene oxides like ethylene oxide propylene oxide copolymers.

US 2005/0072683 A1 discloses high molecular weight surfactants inhibiting the electrodeposition like alkyl polyoxyethylene amines, particularly ethylenediamine ethylene oxide (EO) propylene oxide (PO) block copolymers in combination with a further polyethylene glycol (PEG) suppressor.

WO2004/016828 A2 discloses additives called antimisting agents prepared by polyalkoxylation of amine compounds like triethanolamine, ethylenediamine or diethylenetriamine. Alkoxylated triethanolamine compounds were mentioned to be preferred and were used in the examples.

US 2006/0213780 A1 discloses amine-based copolymers of EO/PO copolymers having at least 70% PO content. The copolymers are mentioned to have block, alternating or random structure. A preferred amine is ethylenediamine.

US 6,444, 1110 B2 discloses an electroplating solution which may comprise, besides a huge variety of additives called surfactants, nitrogen containing additives like ethoxylated amines, polyoxyalkylene amines, alkanol amines, amides like those provided by BASF under the trademark TETRONIC^{®}, all of those being EO/PO block copolymers of ethylene diamine. In the examples only polyglycol type suppressors were used.

EP 440 027 A2 discloses, as suppressors, polyoxyalkylated diamine additives. Alkoxylated diamines are identified to be the most preferred additives.

US 4,347,108 A discloses, as suppressors, those provided by BASF under the trademark TETRONIC^{®}, all of those being EO/PO block copolymers of ethylene diamine. WO 2006/053242 A1 discloses amine-based polyoxyalkylene suppressors. The amine may be methylamine, ethylamine, propylamine, ethylendiamine, diethylenetriamine, diaminopropane, diethyleneglykol diamin or triethylenglycol diamine. The copolymers may have block, alternating or random structure. Compounds provided by BASF under the trademark TETRONIC^{®}, all of those being EO/PO block copolymers of ethylene diamine, and having a molecular mass of up to 5500 g/mol are described to be preferred. The block copolymers of EO and PO are used in the examples.

US 2005/0045485 A1 discloses amine-based polyalkylene oxide copolymers, including diamines, triamines.

US 2006/0213780 A1 discloses amine-based copolymers, e.g. ethylenediamine or laurylamine based EO, PO or BuO copolymers.

Up to now, although sometimes speculatively mentioned in the prior art, amine-based random EO/PO copolymers, or other polyoxyalkylene copolymers, have never been used in the prior art. Furthermore, although sometimes speculatively mentioned, amine-based polyoxyalkylene polymers having at least 3 amine functional groups have also never been used in the prior art. Furthermore those compounds are not believed to be commercially available in the market at the priority date of this application.

With further decreasing aperture size of the features like vias or trenches to dimensions of below 100 nanometers and even below 50 nanometers, respectively, the filling of the interconnects with copper becomes especially challenging, also since the copper seed deposition prior to the copper electrodeposition might exhibit inhomogeneity and nonconformity and thus further decreases the aperture sizes particularly at the top of the apertures. Especially apertures with a seed overhang at the top opening or convex-shaped apertures are challenging to fill and require an especially effective copper growth suppression at the side wall of the feature and the opening of the aperture.

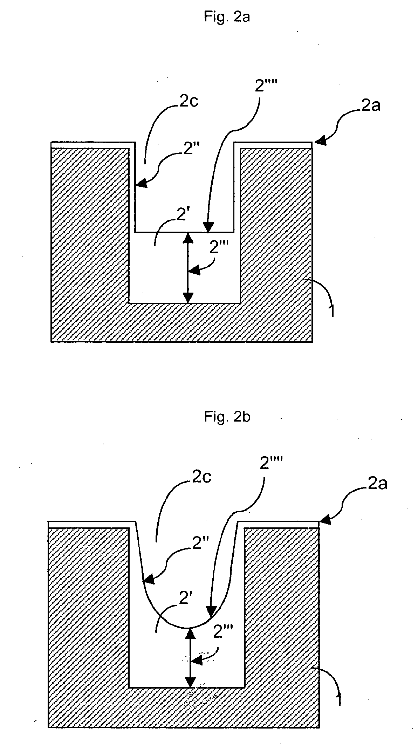

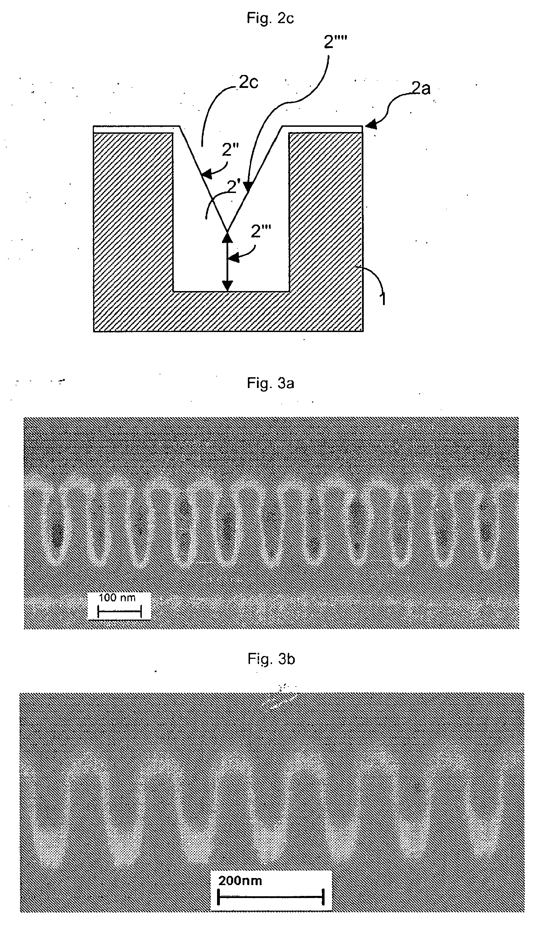

Figs. 3a and 3b show seeded substrates of different dimensions. The seed is shown by the light grey layer on the dark grey structures. Fig. 3a shows a seeded substrate exhibiting impact of the seed on the opening of the features to be filled. Since there is an increasing seed overhang issue with further shrinking feature sizes, as depicted in fig. 3a, there is a serious risk of pinch-off void formation in the upper half of the trench close to the opening if the suppressor does not completely avoid sidewall copper growth (2" in fig. 2a to 2c). As can be seen the openings are reduced to less than the half of the width without the seed layer resulting in effective aperture sizes of about 18 nanometer to 16 nanometer, respectively. The seeded feature has a convex shape. Fig. 3b shows a seeded substrate with wider apertures compared to fig. 3a. After seed deposition the trenches in fig. 3b have a width of about 40 nanometers at the opening and of about 50 nanometers at half height of the trench. The seed at the sidewalls of the trenches has essentially the same thickness at the top of the feature and at the mid of the feature. So the seeded feature essentially has a cylindrical shape.

It is therefore an object of the present invention to provide a copper electroplating additive having good superfilling properties, in particular suppressing agents capable of providing a substantially voidless and seamless filling of features on the nanometer and on the micrometer scale having an aperture size of 30 nanometers or below with a copper electroplating bath. It is a further object of the present invention to provide a copper electroplating additive capable of providing a substantially voidless and seamless filling of features having a convex shape.

Surprisingly, it has now been found, that the use of amine-based polyoxyalkylene suppressing agents based on amines in combination with random oxyalkylene copolymers show extraordinary superfilling properties, particularly if used to fill in features having extremely small aperture sizes and/or high aspect ratios. The present invention provides a new class of highly effective, strong suppressing agents that cope with the seed overhang issue and provide substantially defect free trench filling despite a non-conformal copper seed.

Therefore the present invention provides a process for electrodepositing copper on a substrate comprising submicrometer sized features having an aperture size of 30 nanometers or less, the process comprising
a) contacting a copper plating bath comprising a copper ion source, one or more accelerators, and one or more suppressing agents selected from compounds of formula I 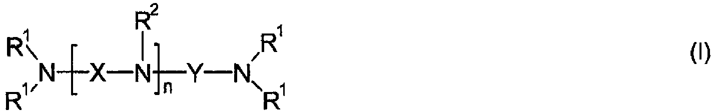 wherein
   - the R¹ radicals are each independently selected from a copolymer of eth-ylene oxide and at least one further C3 to C4 alkylene oxide, said copolymer being a random copolymer.
   - the R² radicals are each independently selected from R¹ or alkyl.
   - X and Y are spacer groups independently, and X for each repeating unit independently, selected from C1 to C6 alkylen and Z-(O-Z)m wherein the Z radicals are each independently selected from C2 to C6 alkylen,
   - n is an integer of from 0 to 10.
   - m is an integer equal to or greater than 1, particularly m=1-10,
   - the content of ethylene oxide in the copolymer of ethylene oxide and the further C3 to C4 alkylene oxide is from 30 to 70 % by weight.
      with the substrate, and
b) applying a current density to the substrate for a time sufficient to fill the submicron size feature with copper..

The advantage of the invention is that suppressing agents are provided that result in a extraordinarily pronounced bottom-up fill copper growth while perfectly suppressing the sidewall copper growth, both leading to a flat growth front and thus providing substantially defect free trench or via fill. The strong sidewall copper growth suppression of the invention enables non-conformally copper seeded features to be substantially void free filled. Moreover the invention provides an overall homogeneous bottom-up fill in neighboring features of dense feature areas.

Furthermore the suppressing agents according to the present invention provide a substantially voidless and seamless filling of features having a convex shape.

The suppressing agents according to the present invention are particularly useful for filling of small features, particularly those having aperture sizes of 30 nanometers or below.

The suppressing agent is obtainable by reacting an amine compound with a mixture of ethylene oxide and at least one compound selected from C3 and C4 alkylene oxides. In this way random copolymers of ethylene oxide and the at least one further C3 and C4 alkylene oxides are generated starting from the active amino functional groups of the amine compound. In the following ethylene oxide is also referred to as EO.

The amine compound is also referred to as the "amine starter".

According to the present invention active amino functional groups are those being able to start an polyalkoxy chain by reacting with the alkylene oxides, i.e. primary amino functional groups -NH2 or secondary amino functional groups -NH-, depending on its position in the molecule. Tertiary or quarternary amino or ammonium groups, respectively, may be present in the amine compound but since they are not able to start an alkylene oxide chain they are no active amino functional groups. Generally terminal amino functional groups are primary ones and non-terminal amino functional groups are secondary ones.

Preferably at least five hydrogen atoms bonded to nitrogen are present in the amine starter. This leads to at least five alkylene oxide copolymer chains present in the suppressing agent.

The suppressing agent to be used in the process according to the invention is selected from compounds of formula I 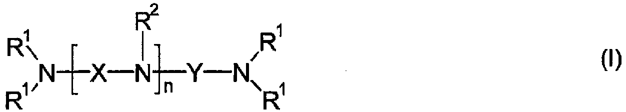 wherein
- the R¹ radicals are each independently selected from a copolymer of ethylene oxide and at least one further C3 to C4 alkylene oxide, said copolymer being a random copolymer.
- the R² radicals are each independently selected from R¹ or alkyl, preferably C1 to C6 alkyl, most preferably methyl or ethyl.
- X and Y are spacer groups independently, and X for each repeating unit independently, selected from C1 to C6 alkylen and Z-(O-Z)m, wherein the Z radicals are each independently selected from C2 to C6 alkylen,
- n is an integer of from 0 to 10.
- m is an integer equal to or greater than 1,

Preferably spacer groups X and Y are independently, and X for each repeating unit independently, selected from C1 to C4 alkylene. Most preferably X and Y are independently, and X for each repeating unit independently, selected from methylene (-CH₂-) or ethylene(-C₂H₄-).

Preferably Z is selected from C2 to C4 alkylene, most preferably from ethylene or propylene.

n is an integer from 0 to 10, more preferably from 1 to 5, most preferably from 1 to 3. Preferably m is an integer from 1 to 10, more preferably from 1 to 5, most preferably from 1 to 3.

In a preferred embodiment the amine compound is selected from ethylene diamine, 1,3-diaminopropane, 1,4-diaminobutane, 1,5-diaminopentane, 1,6-diaminohexane, neopentanediamine, isophoronediamine, 4,9-dioxadodecane-1,12-diamine, 4,7,10-trioxatridecane-1,13-diamine, triethylene glycol diamine, diethylene triamine, (3-(2-aminoethyl)aminopropylamine, 3,3'-iminodi(propylamine), N,N-bis(3-aminopropyl)methylamine, bis(3-dimethylaminopropyl)amine, triethylenetetraamine and N,N'-bis(3-aminopropyl)ethylenediamine or mixtures thereof. Particularly preferred is diethylene triamine.

The C3 to C4 alkylene oxides may be propylene oxide (PO), butylene oxide (BuO) or any isomers thereof.

In another preferred embodiment the C3 to C4 alkylene oxide is selected from propylene oxide (PO). In this case EO/PO copolymer side chains are generated starting from the active amino functional groups

The content of ethylene oxide in the copolymer of ethylene oxide and the further C3 to C4 alkylene oxide can generally be from about 5 % by weight to about 95 % by weight, preferably from about 30 % by weight to about 70 % by weight, particularly preferably between about 35 % by weight to about 65 % by weight.

The molecular weight M_{w} of the suppressing agent may be between about 500 g/mol to about 30 000 g/mol. Preferably the molecular weight M_{w} should be about 6000 g/mol or more, preferably from about 6000 g/mol to about 18000 g/mol, more preferably from about 7000 g/mol to about 19000 g/mol, and most preferably from about 9000 g/mol to about 18000 g/mol. Preferred total amounts of alkylene oxide units in the suppressing agent may be from about 120 to about 360, preferably from about 140 to about 340, most preferably from about 180 to about 300.

Typical total amounts of alkylene oxide units in the suppressing agent may be about 110 ethylene oxide units (EO) and 10 propylene oxide units (PO), about 100 EO and 20 PO, about 90 EO and 30 PO, about 80 EO and 40 PO, about 70 EO and 50 PO, about 60 EO and 60 PO, about 50 EO and 70 PO, about 40 EO and 80 PO, about 30 EO and 90 PO, about 100 EO and 10 butylene oxide (BuO) units, about 90 EO and 20 BO, about 80 EO and 30 BO, about 70 EO and 40 BO, about 60 EO and 50 BO or about 40 EO and 60 BO to about 330 EO and 30 PO units, about 300 EO and 60 PO, about 270 EO and 90 PO, about 240 EO and 120 PO, about 210 EO and 150 PO, about 180 EO and 180 PO, about 150 EO and 210 PO, about 120 EO and 240 PO, about 90 EO and 270 PO, about 300 EO and 30 butylene oxide (BuO) units, about 270 EO and 60 BO, about 240 EO and 90 BO, about 210 EO and 120 BO, about 180 EO and 150 BO, or about 120 EO and 180 BO.

The composition further comprises at least one accelerating agent and, preferably, at least one leveling agent.

Preferably at least part of the features have an aperture size of 25 nanometers or below, most preferably 20 nanometers or below. Also preferred is that at least part of the features have an aspect ratio of 4 or more, preferably of 6 or more, most preferably of 8 or more.

The aperture size according to the present invention means the smallest diameter or free distance of a feature before plating, i.e. after copper seed deposition. A convex shape is a feature having an aperture size being at least 25 %, preferably 30 %, most preferably 50 % smaller than the biggest diameter or free distance of the feature before plating. With reference to fig. 3a V1 and V4 corresponds to the aperture size, V2 and V5 to the biggest diameter of the seeded feature.

A wide variety of copper metal plating baths may be used with the present invention. Metal electroplating baths typically contain a metal ion source, an electrolyte, and a polymeric suppressing agent.

The metal ion source may be any compound capable of releasing metal ions to be deposited in the electroplating bath in sufficient amount, i.e. is at least partially soluble in the electroplating bath. It is preferred that the metal ion source is soluble in the plating bath. Suitable metal ion sources are metal salts and include, but are not limited to, metal sulfates, metal halides, metal acetates, metal nitrates, metal fluoroborates, metal alkylsulfonates, metal arylsulfonates, metal sulfamates, metal gluconates and the like. It is preferred that the metal is copper. It is further preferred that the source of metal ions is copper sulfate, copper chloride, copper acetate, copper citrate, copper nitrate, copper fluoroborate, copper methane sulfonate, copper phenyl sulfonate and copper p-toluene sulfonate. Copper sulfate pentahydrate and copper methane sulfonate are particularly preferred. Such metal salts are generally commercially available and may be used without further purification.

The metal ion source may be used in the present invention in any amount that provides sufficient metal ions for electroplating on a substrate. Suitable metal ion metal sources include, but are not limited to, tin salts, copper salts, and the like. When the metal is copper, the copper salt is typically present in an amount in the range of from about 1 to about 300 g/L of plating solution. It will be appreciated mixtures of metal salts may be electroplated according to the present invention. Thus, alloys, such as copper-tin having up to about 2 percent by weight tin, may be advantageously plated according to the present invention. The amounts of each of the metal salts in such mixtures depend upon the particular alloy to be plated and is well known to those skilled in the art.

In general, besides the metal ion source and at least one of the suppressing agents according to the present invention the present metal electroplating compositions preferably include electrolyte, i. e. acidic or alkaline electrolyte, one or more sources of metal ions, optionally halide ions, and optionally other additives like accelerators and/or levelers. Such baths are typically aqueous. The water may be present in a wide range of amounts. Any type of water may be used, such as distilled, deionized or tap.

The electroplating baths of the present invention may be prepared by combining the components in any order. It is preferred that the inorganic components such as metal salts, water, electrolyte and optional halide ion source, are first added to the bath vessel followed by the organic components such as leveling agents, accelerators, suppressors, surfactants and the like.

Typically, the plating baths of the present invention may be used at any temperature from 10 to 65 degrees C or higher. It is preferred that the temperature of the plating baths is from 10 to 35 degrees C and more preferably from 15 degrees to 30 degrees C.

Suitable electrolytes include such as, but not limited to, sulfuric acid, acetic acid, fluoroboric acid, alkylsulfonic acids such as methanesulfonic acid, ethanesulfonic acid, propanesulfonic acid and trifluoromethane sulfonic acid, arylsulfonic acids such as phenyl sulfonic acid and toluenesulfonic acid, sulfamic acid, hydrochloric acid, phosphoric acid, tetraalkylammonium hydroxide, preferably tetramethylammonium hydroxide, sodium hydroxide, potassium hydroxide and the like. Acids are typically present in an amount in the range of from about 1 to about 300 g/l, alkaline electrolytes are typically present in an amount of about 0.1 to about 20 g/l or to yield a pH of 8 to 13 respectively, and more typically to yield a pH of 9 to 12.

Such electrolytes may optionally contain a source of halide ions, such as chloride ions as in copper chloride or hydrochloric acid. A wide range of halide ion concentrations may be used in the present invention such as from about 0 to about 500 ppm. Typically, the halide ion concentration is in the range of from about 10 to about 100 ppm based on the plating bath. It is preferred that the electrolyte is sulfuric acid or methanesulfonic acid, and preferably a mixture of sulfuric acid or methanesulfonic acid and a source of chloride ions. The acids and sources of halide ions useful in the present invention are generally commercially available and may be used without further purification.

Any accelerators may be advantageously used in the plating baths according to the present invention. Accelerators useful in the present invention include, but are not limited to, compounds comprising one or more sulphur atom and a sulfonic/phosphonic acid or their salts.

The generally preferred accelerators have the general structure MO₃X-R²¹-(S)ₙ-R²², with:
- M is a hydrogen or an alkali metal (preferably Na or K)
- X is P or S
- n = 1 to 6
- R²¹ is selected from C1-C8 alkyl group or heteroalkyl group, an aryl group or a heteroaromatic group. Heteroalkyl groups will have one or more heteroatom (N, S, O) and 1-12 carbons. Carbocyclic aryl groups are typical aryl groups, such as phenyl, naphtyl. Heteroaromatic groups are also suitable aryl groups and contain one or more N,O or S atom and 1-3 separate or fused rings.
- R²² is selected from H or (-S-R^{21'}XO₃M), with R^{21'} being identical or different from R²¹.

More specifically, useful accelerators include those of the following formulae:

MO₃S-R²¹-SH

MO₃S-R²¹-S-S-R^{21'}-SO₃M

MO₃S-Ar-S-S-Ar-SO₃M

with R²¹ is as defined above and Ar is Aryl.

Particularly preferred accelerating agents are:
- SPS: bis-(3-sulfopropyl)-disulfide disodium salt
- MPS: 3-mercapto-1-propansulfonic acid, sodium salt

Other examples of accelerators, used alone or in mixture, include, but are not limited to: MES (2-Mercaptoethanesulfonic acid, sodium salt); DPS (N,N-dimethyldithiocarbamic acid (3-sulfopropylester), sodium salt); UPS (3-[(amino-iminomethyl)-thio]-1-propylsulfonic acid); ZPS (3-(2-benzthiazolylthio)-1-propanesulfonic acid, sodium salt); 3-mercapto-propylsulfonicacid-(3-sulfopropyl)ester; methyl-(ω̅-̅sulphopropyl)-disulfide, disodium salt; methyl-(ω̅-sulphopropyl)-trisulfide, disodium salt.

Such accelerators are typically used in an amount of about 0.1 ppm to about 3000 ppm, based on the total weight of the plating bath. Particularly suitable amounts of accelerator useful in the present invention are 1 to 500 ppm, and more particularly 2 to 100 ppm.

Any additional suppressor may be advantageously used in the present invention. Suppressors useful in the present invention include, but are not limited to, polymeric materials, particularly those having heteroatom substitution, and more particularly oxygen substitution. It is preferred that the suppressor is a polyalkyleneoxide. Suitable suppressors include polyethylene glycol copolymers, particularly polyethylene glycol polypropylene glycol copolymers. The arrangement of ethylene oxide and propylene oxide of suitable suppressors may be block, alternating, gradient, or random. The polyalkylene glycol may comprise further alkylene oxide building blocks such as butylene oxide. Preferably, the average molecular weight of suitable suppressors exceeds about 2000 g/mol. The starting molecules of suitable polyalkylene glycol may be alkyl alcohols such as methanol, ethanol, propanol, n-butanol and the like, aryl alcohols such as phenols and bisphenols, alkaryl alcohols such as benzyl alcohol, polyol starters such as glycol, glycerin, trimethylol propane, pentaerythritol, sorbitol, carbohydrates such as saccharose, and the like, amines and oligoamines such as alkyl amines, aryl amines such as aniline, triethanol amine, ethylene diamine, and the like, amides, lactams, heterocyclic amines such as imidazol and carboxylic acids. Optionally, polyalkylene glycol suppressors may be functionalized by ionic groups such as sulfate, sulfonate, ammonium, and the like.

When suppressors are used, they are typically present in an amount in the range of from about 1 to about 10,000 ppm based on the weight of the bath, and preferably from about 5 to about 10,000 ppm.

Leveling agents can advantageously be used in the metal plating baths according to the present invention. The terms "leveling agent" and "leveler" are used herein synonymously.

Suitable leveling agents include, but are not limited to, one or more of polyethylene imine and derivatives thereof, quaternized polyethylene imine, polyglycine, poly(allylamine), polyaniline, polyurea, polyacrylamide, poly(melamine-coformaldehyde), reaction products of amines with epichlorohydrin, reaction products of an amine, epichlorohydrin, and polyalkylene oxide, reaction products of an amine with a polyepoxide, polyvinylpyridine, polyvinylimidazole, polyvinylpyrrolidone, or copolymers thereof, nigrosines, pentamethy-para-rosaniline hydrohalide, hexamethyl-pararosaniline hydrohalide, trialkanolamines and their derivatives or compounds containing a functional group of the formula N-R-S, where R is a substituted alkyl, unsubstituted alkyl, substituted aryl or unsubstituted aryl. Typically, the alkyl groups are (C1-C6)alkyl and preferably (C1-C4)alkyl. In general, the aryl groups include (C6-C20)aryl, preferably (C6-C10)aryl. Such aryl groups may further include heteroatoms, such as sulfur, nitrogen and oxygen. It is preferred that the aryl group is phenyl or napthyl. The compounds containing a functional group of the formula N-R-S are generally known, are generally commercially available and may be used without further purification.

In such compounds containing the N-R-S functional group, the sulfur ("S") and/or the nitrogen ("N") may be attached to such compounds with single or double bonds. When the sulfur is attached to such compounds with a single bond, the sulfur will have another substituent group, such as but not limited to hydrogen, (C1-C12)alkyl, (C2-C12)alkenyl, (C6-C20)aryl, (C1-C12)alkylthio, (C2-C12)alkenylthio, (C6-C20)arylthio and the like. Likewise, the nitrogen will have one or more substituent groups, such as but not limited to hydrogen, (C1-C12)alkyl, (C2-C12)alkenyl, (C7-C10)aryl, and the like. The N-R-S functional group may be acyclic or cyclic. Compounds containing cyclic N-R-S functional groups include those having either the nitrogen or the sulfur or both the nitrogen and the sulfur within the ring system.

By "substituted alkyl" is meant that one or more of the hydrogens on the alkyl group is replaced with another substituent group, such as, but not limited to, cyano, hydroxy, halo, (C1-C6)alkoxy, (C1-C6)alkylthio, thiol, nitro, and the like. By "substituted aryl" is meant that one or more hydrogens on the aryl ring are replaced with one or more substituent groups, such as, but not limited to, cyano, hydroxyl, haio, (C1-C6)alkoxy, (C1-C6)alkyl, (C2-C6)alkenyl, (C1-C6)alkylthio, thiol, nitro, and the like. "Aryl" includes carbocyclic and heterocyclic aromatic systems, such as, but not limited to, phenyl, naphthyl and the like.

Polyalkanolamines, alkoxylated polyalkanolamines, functionalized polyalkanolamines, and functionalized alkoxylated polyalkanolamines are particularly preferred levelling agents in copper electroplating baths. Such Polyalkanolamines are described in European patent application No. 08172330.6, which is incorporated herein by reference.

Polyalkanolamines can be obtained by condensing at least one trialkanolamine of the general formula N(R¹¹-OH)₃ (Ia) and/or at least one dialkanolamine of the general formula R¹²-N(R¹¹-OH)₂ (Ib) to give a polyalkanolamine(II) (stage A), where
- the R¹¹ radicals are each independently selected from a divalent, linear and branched aliphatic hydrocarbon radical having from 2 to 6 carbon atoms, and
- the R¹² radicals are each selected from hydrogen and aliphatic, cycloaliphatic and aromatic hydrocarbon radicals, all of which may be linear or branched, having from 1 to 30 carbon atoms.

The alkanolamine can be used as such or may optionally be alkoxylated, functionalized or alkoxylated and functionalized to get alkoxylated polyalkanolamines (III), functionalized polyalkanolamines (IV) or functionalized alkoxylated polyalkanolamines (V).

Alkoxylated polyalkanolamines (III) can be obtained by alkoxylating polyalkanolamine (II) with C₂- to C₁₂-alkylene oxides, styrene oxide, glycidol, or glycidyl ethers with the proviso that the average degree of alkoxylation is from 0.1 to 200 per OH group and-where present - secondary amino group (stage B).

Functionalized polyalkanolamines (IV) can be obtained by functionalizing polyalkanolamine (II) with suitable functionalization reagents which are capable of reaction with hydroxyl groups and/or amino groups (stage C).

Functionalized alkoxylated polyalkanolamines (V) can be obtained by functionalizing alkoxylated polyalkanolamine (III) with suitable functionalization reagents which are capable of reaction with hydroxyl groups and/or amino groups (stage D).

The trialkanolamines (Ia) and/or dialkanolamines (Ib) used in stage (A) have the general formulae N(R¹¹-OH)₃ (Ia) and R¹²-N(R¹¹-OH)₂ (Ib).

The R¹¹ radicals are in each case independently a divalent linear or branched aliphatic hydrocarbon radical having from 2 to 6 carbon atoms, preferably 2 or 3 carbon atoms. Examples of such radicals comprise ethane-1,2-diyl, propane-1,3-diyl, propane-1,2-diyl, 2-methylpropane-1,2-diyl, 2,2-dimethylpropane-1,3-diyl, butane-1,4-diyl, butane-1,3-diyl (= 1-methylpropane-1,3-diyl), butane-1,2-diyl, butane-2,3-diyl, 2-methylbutane-1,3-diyl, 3-methylbutane-1,3-diyl (= 1,1-dimethylpropane-1,3-diyl), pentane-1,4-diyl, pentane-1,5-diyl, pentane-2,5-diyl, 2-methylpentane-2,5-diyl (= 1,1-dimethylbutane-1,3-diyl) and hexane-1,6-diyl. The radicals are preferably ethane-1,2-diyl, propane-1,3-diyl or propane-1,2-diyl.

The R¹² radical is hydrogen and/or linear or branched aliphatic, cycloaliphatic and/or aromatic hydrocarbon radicals having from 1 to 30 carbon atoms, preferably from 1 to 20 carbon atoms and more preferably from 1 to 10 carbon atoms. Aromatic radicals may of course also have aliphatic substituents. R¹² is preferably hydrogen or aliphatic hydrocarbon radicals having from 1 to 4 carbon atoms.

Examples of preferred trialkanolamines (Ia) comprise triethanolamine, triisopropanolamine and tributan-2-olamine, particular preference is given to triethanolamine.

Examples of preferred dialkanolamines (Ib) comprise diethanolamine, N-methyldiethanolamine, N,N-bis(2-hydroxypropyl)-N-methylamine, N,N-bis(2-hydroxybutyl)-N-methylamine, N-isopropyldiethanolamine, N-n-butyldiethanolamine, N-secbutyldiethanolamine, N-cyclohexyldiethanolamine, N-benzyldiethanolamine, N-4-tolyldiethanolamine or N,N-bis(2-hydroxyethyl)aniline. Particular preference is given to diethanolamine.

In addition to the trialkanolamines (Ia) and/or dialkanolamines (Ib) it is optionally possible to use further components (Ic) having two hydroxyl and/or amino groups for the polycondensation.

The polycondensation of components (Ia) and/or (Ib) and optionally (Ic) can be carried out by methods known in principle to those skilled in the art while heating the components, with elimination of water. Suitable methods are disclosed, for example, by EP 441 198 A2. It will be appreciated that it is in each case also possible to use mixtures of different components (Ia), (Ib) or (Ic).

The condensation is performed typically at temperatures of from 120 to 280 degree C, preferably from 150 to 260 degree C and more preferably from 180 to 240 degree C. The water formed is preferably distilled off. The reaction time is typically from 1 to 16 h, preferably from 2 to 8 h. The degree of condensation can be controlled in a simple manner through the reaction temperature and time.

The polycondensation is preferably carried out in the presence of an acid, preferably phosphorous acid (H₃PO₃) and/or hypophosphorous acid (H₃PO₂). Preferred amounts are from 0.05 to 2% by weight, preferably from 0.1 to 1% by weight, based on the components to be condensed. In addition to the acid, it is also possible to use additional catalysts, for example, zinc halides or aluminum sulfate, if appropriate in a mixture with acetic acid, as disclosed, for example by US 4,505,839.

The viscosity of the resulting polyalkanolamines (II) is typically in the range from 1000 to 50 000 mPa.s, preferably from 2000 to 20 000 mPa.s and more preferably from 3000 to 13000 mPa.s (each measured on the undiluted product at 20 degree C).

The mean molar mass Mₙ (number average) of the resulting polyalkanolamines (II) is typically in the range from 250 to 50 000 g/mole, preferably from 500 to 40 000 g/mole, more preferably from 1000 to 20 000 g/mole and most preferably from 1000 to 7500 g/mole.

The mean molar mass M_{w} (weight average) of the resulting polyalkanolamines (II) is typically in the range from 250 to 50 000 g/mole, preferably from 500 to 30 000 g/mole, more preferably from 1000 to 20 000 g/mole.

The resulting polyalkanolamine (II) preferably has a polydispersity (M_{w}/Mₙ) in the range of 1 to 10, and in particular in the range of 1 to 5.

The polyalkanolamines (II) can optionally be alkoxylated in a second stage (B). In this step, the OH groups and any secondary amino groups present react with alkylene oxides to form terminal polyether groups.

Polyalkanolamines (II) can optionally be functionalized in a further reaction step (C). An additional functionalization can serve to modify the properties of the polyalkanolamines (II). To this end, the hydroxyl groups and/or amino groups present in the polyalkanolamines (II) are converted by means of suitable agents which are capable of reaction with hydroxyl groups and/or amino groups. This forms functionalized polyalkanolamines (IV).

The alkoxylated polyalkanolamines (III) can optionally be functionalized in a further reaction step (D). An additional functionalization can serve to modify the properties of the alkoxylated polyalkanolamines (III). To this end, the hydroxyl groups and/or amino groups present in the alkoxylated polyalkanolamines (III) are converted by means of suitable agents which are capable of reaction with hydroxyl groups and/or amino groups. This forms functionalized alkoxylated polyalkanolamines (V).

In general, the total amount of leveling agents in the electroplating bath is from 0.5 ppm to 10000 ppm based on the total weight of the plating bath. The leveling agents according to the present invention are typically used in a total amount of from about 0.1 ppm to about 1000 ppm based on the total weight of the plating bath and more typically from 1 to 100 ppm, although greater or lesser amounts may be used.

The electroplating baths according to the present invention may include one or more optional additives. Such optional additives include, but are not limited to, accelerators, suppressors, surfactants and the like. Such suppressors and accelerators are generally known in the art. It will be clear to one skilled in the art which suppressors and/or accelerators to use and in what amounts.

A large variety of additives may typically be used in the bath to provide desired surface finishes for the Cu plated metal. Usually more than one additive is used with each additive forming a desired function. Advantageously, the electroplating baths may contain one or more of accelerators, suppressors, levelers, sources of halide ions, grain refiners and mixtures thereof. Most preferably the electroplating bath contains both, an accelerator and a leveler in addition to the suppressor according to the present invention. Other additives may also be suitably used in the present electroplating baths.

The present invention is useful for depositing a metal layer, particularly a copper layer, on a variety of substrates, particularly those having submicron and variously sized apertures. For example, the present invention is particularly suitable for depositing copper on integrated circuit substrates, such as semiconductor devices, with small diameter vias, trenches or other apertures. In one embodiment, semiconductor devices are plated according to the present invention. Such semiconductor devices include, but are not limited to, wafers used in the manufacture of integrated circuits.

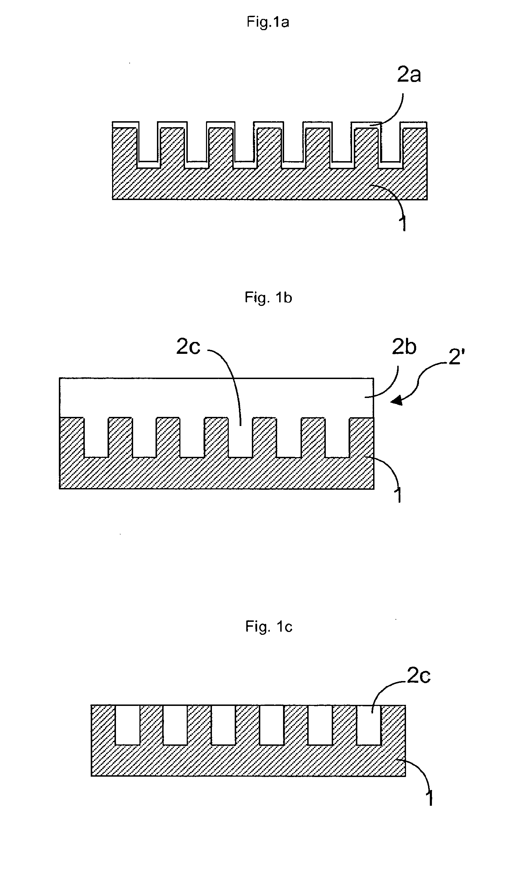

The general process of copper electrodeposition on semiconductor integrated circuit substrates is described with respect to figs. 1 and 2 without restricting the invention thereto.

Fig. 1 a shows a dielectric substrate 1 seeded with a copper layer 2a. With reference to fig. 1b a copper layer 2' is deposited onto the dielectric substrate 1 by electrodeposition. The trenches 2c of the substrate 1 are filled and an overplating of copper 2b, also referred to as "overburden", is generated on top of the whole structured substrate. During the process, after optional annealing, the overburden of copper 2b is removed by chemical mechanical planarization (CMP), as depicted in fig. 1c.

A key aspect when filling the trenches 2c of the substrate 1 with copper by electrodeposition is to achieve a copper layer that is free of defects, especially free of voids and seams. This can be realized by initiating the copper growth at the bottom of the trench with the copper growing up to the mouth of the trench while suppressing copper growth at the sidewalls of the trench. This manner of trench filling, the so-called super-filling or bottom-up-filling, depicted in fig. 2a, is sought to achieve by adding certain additives to the plating bath: the accelerator and the suppressor. It is a sensitive interplay between these two additives that has to be carefully adjusted to obtain a trench filling free of any defects.

Bottom-up-filling as shown in fig. 2a can be achieved with the accelerator preferably accumulating and adsorbing on the copper bottom of the trench and thus boosting the copper growth 2"', and with the suppressor adsorbing on the sidewalls of the trench suppressing the copper growth 2". Depending on the chemical structure of the suppressor and thus on its suppressing ability, the trench filling can proceed with variably shaped copper growth fronts 2"", depicted in figs. 2a to 2c. A perfectly working suppressor with complete sidewall coverage and full sidewall growth suppression 2" is shown in fig. 2a. In this case the growth front 2"" is flat with solely growing bottom-up copper 2"'. A less effective suppressor results in a copper growth front 2"" depicted in fig. 2b. Slight sidewall copper growth 2" with predominant bottom-up copper growth 2"" gives an overall U-shaped growth front 2"". A weak suppressor evolves a V-shaped growth front 2"" due to significant sidewall copper growth 2", as depicted in fig. 2c. A V-shaped copper growth front 2"" implicates a serious risk of void formation when the trench is filled. With a perfectly conformal copper seeded trench the U-shaped copper growth front 2"" as shown in fig. 2b might provide satisfying trench filling. But since there is an increasing seed overhang issue and/or convex-shaped features with further shrinking feature sizes, as depicted in fig. 3a, there is a serious risk of pinch-off void formation in the upper half of the trench close to the opening if the suppressor does not completely avoid sidewall copper growth 2". The present invention provides a new class of highly effective, strong suppressing agents that cope with the seed overhang issue and provide defect free trench filling despite a non-conformal copper seed.

The advantage of the invention is that suppressing agents are provided that result in a extraordinarily pronounced bottom-up fill copper growth while perfectly suppressing the sidewall copper growth, both leading to a flat growth front and thus providing defect free trench fill. The strong sidewall copper growth suppression of the invention enables non-conformal copper seeded features and/or convex-shaped features to be substantially void free filled. Moreover the invention provides an overall homogeneous bottom-up fill in neighboring features of dense feature areas.

Typically, substrates are electroplated by contacting the substrate with the plating baths of the present invention. The substrate typically functions as the cathode. The plating bath contains an anode, which may be soluble or insoluble. Optionally, cathode and anode may be separated by a membrane. Potential is typically applied to the cathode. Sufficient current density is applied and plating performed for a period of time sufficient to deposit a metal layer, such as a copper layer, having a desired thickness on the substrate. Suitable current densities include, but are not limited to, the range of 1 to 250 mA/cm². Typically, the current density is in the range of 1 to 60 mA/cm² when used to deposit copper in the manufacture of integrated circuits. The specific current density depends on the substrate to be plated, the leveling agent selected and the like. Such current density choice is within the abilities of those skilled in the art. The applied current may be a direct current (DC), a pulse current (PC), a pulse reverse current (PRC) or other suitable current.

In general, when the present invention is used to deposit metal on a substrate such as a wafer used in the manufacture of an integrated circuit, the plating baths are agitated during use. Any suitable agitation method may be used with the present invention and such methods are well-known in the art. Suitable agitation methods include, but are not limited to, inert gas or air sparging, work piece agitation, impingement and the like. Such methods are known to those skilled in the art. When the present invention is used to plate an integrated circuit substrate, such as a wafer, the wafer may be rotated such as from 1 to 150 RPM and the plating solution contacts the rotating wafer, such as by pumping or spraying. In the alternative, the wafer need not be rotated where the flow of the plating bath is sufficient to provide the desired metal deposit.

Metal, particularly copper, is deposited in apertures according to the present invention without substantially forming voids within the metal deposit. By the term "without substantially forming voids", it is meant that 95% of the plated apertures are void-free. It is preferred that 98% of the plated apertures are void-free, mostly preferred is that all plated apertures are void-free.

While the process of the present invention has been generally described with reference to semiconductor manufacture, it will be appreciated that the present invention may be useful in any electrolytic process where metal filled small features that are substantially free of voids are desired. Such processes include printed wiring board manufacture. For example, the present plating baths may be useful for the plating of vias, pads or traces on a printed wiring board, as well as for bump plating on wafers. Other suitable processes include packaging and interconnect manufacture. Accordingly, suitable substrates include lead frames, interconnects, printed wiring boards, and the like.

Plating equipment for plating semiconductor substrates are well known. Plating equipment comprises an electroplating tank which holds Cu electrolyte and which is made of a suitable material such as plastic or other material inert to the electrolytic plating solution. The tank may be cylindrical, especially for wafer plating. A cathode is horizontally disposed at the upper part of tank and may be any type substrate such as a silicon wafer having openings such as trenches and vias. The wafer substrate is typically coated with a seed layer of Cu or other metal or a metal containing layer to initiate plating thereon. A Cu seed layer may be applied by chemical vapor deposition (CVD), physical vapor deposition (PVD), or the like. An anode is also preferably circular for wafer plating and is horizontally disposed at the lower part of tank forming a space between the anode and cathode. The anode is typically a soluble anode.

These bath additives are useful in combination with membrane technology being developed by various tool manufacturers. In this system, the anode may be isolated from the organic bath additives by a membrane. The purpose of the separation of the anode and the organic bath additives is to minimize the oxidation of the organic bath additives.

The cathode substrate and anode are electrically connected by wiring and, respectively, to a rectifier (power supply). The cathode substrate for direct or pulse current has a net negative charge so that Cu ions in the solution are reduced at the cathode substrate forming plated Cu metal on the cathode surface. An oxidation reaction takes place at the anode. The cathode and anode may be horizontally or vertically disposed in the tank.

Metal, particularly copper, is deposited in apertures according to the present invention without substantially forming voids within the metal deposit. By the term "without substantially forming voids", it is meant that 95% of the plated apertures are void-free. It is preferred that the plated apertures are void-free.

While the process of the present invention has been generally described with reference to semiconductor manufacture, it will be appreciated that the present invention may be useful in any electrolytic process where a substantially void-free copper deposit having high reflectivity is desired. Accordingly, suitable substrates include lead frames, interconnects, printed wiring boards, and the like.

All percent, ppm or comparable values refer to the weight with respect to the total weight of the respective composition except where otherwise indicated.

The following examples shall further illustrate the present invention without restricting the scope of this invention.

### Examples

Two N-containing EO-PO copolymers have been synthesized by polyalkoxylation of the respective N-containing starting molecules. The compositions of suppressors 1-2 are given in Table 1.

**Table 1**

| Suppressor | Starter | EO number/ starter | PO number/ starter | arrangement | Fill performance |
|---|---|---|---|---|---|
| 1 | Diethylenetriamine | 120 | 120 | random | + |
| 2 (comparative example) | Diethylenetriamine | 120 | 120 | EO-PO block | - |

The amine number was determined according to DIN 53176 by titration of a solution of the polymer in acetic acid with perchloric acid.

The molecular weight distribution d was determined by size exclusion chromatography (GPC) with THF as eluent and using PSS SDV columns as solid phase.

### Example 1: Synthesis of suppressor 1

Diethylenetriamine (389 g) and water (19.5 g) were placed into a 2L autoclave at 70 °C. After nitrogen neutralization ethylene oxide (830 g) was added in portions at 90 °C over a period of 8 h 30 min. To complete the reaction, the mixture was allowed to post-react for 3 h. Then the temperature was decreased to 60 °C and the mixture was stirred overnight. Then the reaction mixture was stripped with nitrogen and volatile compounds were removed in vacuo at 80°C. A highly viscous light yellow intermediate product (1240 g) having an amine number of 9.12 mmol/g was obtained.

The intermediate product (48.5 g) and aqueous potassium hydroxide solution (concentration: 50 w% KOH; 1.45 g) were placed into a 2L autoclave at 80 °C. After nitrogen neutralization the solvent was removed for 2 h at 100 °C under vacuo (< 10 mbar). Then the pressure was increased to 2 bar and a mixture of ethylene oxide (330 g) and propylene oxide (479 g) was added in portions at 140 °C over a period of 10 h 30 min. To complete the reaction, the mixture was allowed to post-react for 7 h at the same temperature. Then, the temperature was decreased to 60 °C and the mixture was stirred overnight. Subsequently, the reaction mixture was stripped with nitrogen and volatile compounds were removed in vacuo at 80 °C. An intermediate product was obtained as a light brown liquid (867 g) having an amine number of 0.527 mmol/g.

The intermediate product (323 g) was placed into a 2L autoclave at 80 °C. After nitrogen neutralization the solvent was removed for 20 min at 80-120 °C under vacuo (< 10 mbar). Then the pressure was increased to 2 bar and a mixture of ethylene oxide (158 g) and propylene oxide (207 g) was added in portions at 140 °C over a period of 7 h. To complete the reaction, the mixture was allowed to post-react for 7 h at the same temperature. Then, the temperature was decreased to 60 °C and the mixture was stirred over the weekend. Subsequently, the reaction mixture was stripped with nitrogen and volatile compounds were removed in vacuo at 80 °C. Suppressor 2 was obtained as a light brown liquid (694 g) having an amine number of 0.243 mmol/g. GPC: d = 1.20.

### Example 2: Synthesis of suppressor 2

Diethylenetriamine (382 g) and water (19.1 g) were placed into a 2L autoclave at 70 °C. After nitrogen neutralization ethylene oxide (814 g) was added in portions at 90 °C over a period of 8 h. To complete the reaction, the mixture was allowed to post-react for 3 h. Then the temperature was decreased to 60 °C and the mixture was stirred overnight. Then the reaction mixture was stripped with nitrogen and volatile compounds were removed in vacuo at 80°C. A highly viscous light yellow intermediate product (1180 g) was obtained.

The intermediate product (79.7 g) and aqueous potassium hydroxide solution (concentration: 40 w% KOH; 2.99 g) were placed into a 2L autoclave at 80 °C. After nitrogen neutralization the solvent was removed for 2 h at 100 °C under vacuo (< 10 mbar). Then the pressure was increased to 2 bar and ethylene oxide (1266 g) was added in portions at 120 °C over a period of 11 h. To complete the reaction, the mixture was allowed to post-react for 3 h at the same temperature. Then, the temperature was decreased to 60 °C and the mixture was stirred overnight. Subsequently, the reaction mixture was stripped with nitrogen and volatile compounds were removed in vacuo at 80 °C. A second intermediate product was obtained as a brown solid (1366 g) having an amine number of 0.584 mmol/g. GPC: d = 1.47.

The second intermediate product (311 g) was placed into a 2L autoclave at 80 °C. After nitrogen neutralization the solvent was removed for 1 h at 100 °C under vacuo (< 10 mbar). Then the pressure was increased to 2 bar and propylene oxide (397 g) was added in portions at 140 °C over a period of 4 h 10 min. To complete the reaction, the mixture was allowed to post-react for 3 h at the same temperature. Then, the temperature was decreased to 60 °C and the mixture was stirred overnight. Subsequently, the reaction mixture was stripped with nitrogen and volatile compounds were removed in vacuo at 80 °C. Suppressor 2 was obtained as a light brown liquid (705 g) having an amine number of 0.258 mmol/g. GPC: d = 1.47.

Figs. 3a and 3b show the feature sizes of the copper seeded wafer substrates that were used for electroplating with the different plating baths described in the following sections. After copper seed deposition the trenches in fig. 3a had a width of 15.6 to 17.9 nanometer at the trench opening, a width of 34.6 to 36.8 nanometer at half height of the trench, and were 176.4 nanometer deep. After copper seed deposition the trenches in fig. 3b had a width of about 40 nanometer at the trench opening, a width of about 50 nanometer at half height of the trench, and were about 95 nanometer deep.

### Example 3:

A plating bath was prepared by combining DI water, 40 g/l copper as copper sulfate, 10 g/l sulfuric acid, 0.050 g/l chloride ion as HCl, 0.028 g/l of SPS and 2.00 ml/l of a 5.3 wt % solution in DI water of suppressor 1 as prepared in example 1.

A copper layer was electroplated onto a wafer substrate with feature sizes shown in fig. 3a provided with a copper seed layer by contacting the wafer substrate with the above described plating bath at 25 degrees C applying a direct current of -5 mA/cm² for 3 s. The thus electroplated copper layer was investigated by SEM inspection.

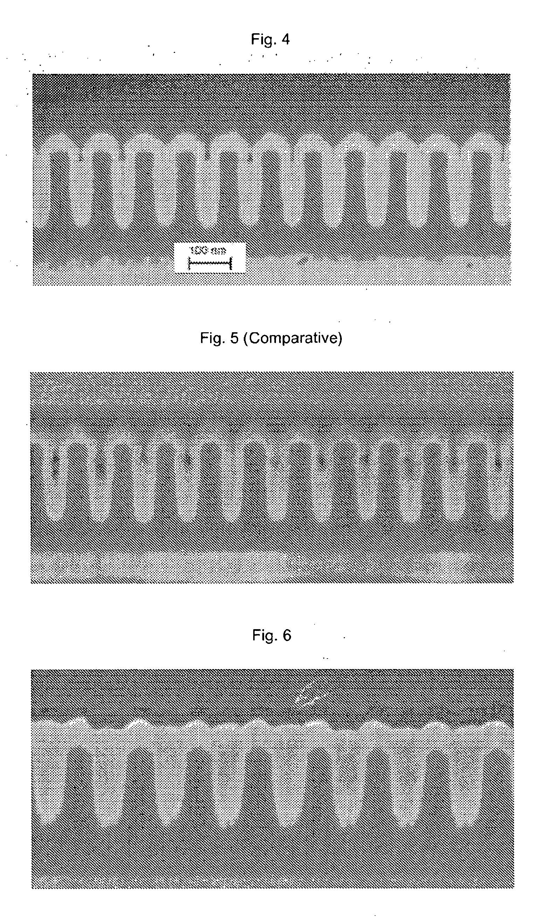

The result is shown in fig. 4 providing the SEM image of partly filled trenches exhibiting the bottom-up filling with almost no copper deposition on the sidewall of the trenches. The neighboring trenches are almost equally filled without exhibiting voids or seams. The strong suppressing effect on the trench sidewalls can be clearly seen since the small feature openings are still obvious and did not close while filling the trenches. During the 3s plating there was no significant amount of copper deposited at the trench sidewalls close to the opening thus avoiding formation of pinch-off voids.

### Comparative Example 4

A plating bath was prepared by combining DI water, 40 g/l copper as copper sulfate, 10 g/l sulfuric acid, 0.050 g/l chloride ion as HCl, 0.028 g/l of SPS, and 5.00 ml/l of a 5.0 wt % solution in DI water of suppressor 2 as prepared in example 2.

A copper layer was electroplated onto a wafer substrate with feature sizes shown in fig. 3a provided with a copper seed layer by contacting the wafer substrate with the above described plating bath at 25 degrees C applying a direct current of -5 mA/cm² for 3 s. The thus electroplated copper layer was investigated by SEM inspection.

The resulting SEM image is shown in fig. 5 which exhibits neighboring trenches that are unequally partly filled with copper. The trenches do not exhibit a flat and well-defined growth front parallel to the trench bottom but a growth front distributed over the whole surface of the trenches indicated by the slit-shaped wholes in the trenches. Several trenches are already closed at the openings of the trenches due to significant sidewall copper growth resulting in void formation.

### Comparative Example 5:

A plating bath was prepared by combining DI water, 40 g/l copper as copper sulfate, 10 g/l sulfuric acid, 0.050 g/l chloride ion as HCl, 0.028 g/l of SPS and 2.00 ml/l of a 5.3 wt % solution in DI water of suppressor 1 as prepared in example 1.

A copper layer was electroplated onto a wafer substrate with feature sizes shown in fig. 3b provided with a copper seed layer by contacting the wafer substrate with the above described plating bath at 25 degrees C applying a direct current of -6.37 mA/cm² for 6 s. The thus electroplated copper layer was investigated by SEM inspection.

The result is shown in fig. 6 providing the SEM image of completely filled trenches. The neighboring trenches are equally filled without exhibiting voids or seams. The copper growth front over the trenches is flat and thus indicates bottom-up filling and strong suppression of the copper growth at the sidewalls of the trenches, as depicted in fig. 2a.

### Comparative Example 6

A plating bath was prepared by combining DI water, 40 g/I copper as copper sulfate, 10 g/l sulfuric acid, 0.050 g/l chloride ion as HCl, 0.028 g/l of SPS, and 5.00 ml/l of a 5.0 wt % solution in DI water of suppressor 2 as prepared in example 2.

A copper layer was electroplated onto a wafer substrate with feature sizes shown in fig. 3b provided with a copper seed layer by contacting the wafer substrate with the above described plating bath at 25 degrees C applying a direct current of -6.37 mA/cm² for 6 s. The thus electroplated copper layer was investigated by SEM inspection.

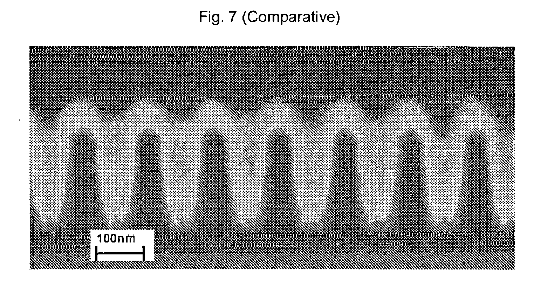

The resulting SEM image is shown in fig. 7 which exhibits neighboring trenches that are unequally filled with copper. The growth front over the trenches is not as perfectly flat as in example 5 but resembles more a U- or a V-shape, as depicted in figs. 2b and 2c. The trenches are filled without exhibiting voids or seams but less fast compared to example 5.

## Claims

1. A process for electrodepositing copper on a substrate comprising submicrometer sized features having an aperture size of 30 nanometers or less, the process comprising
a) contacting a copper plating bath comprising a copper ion source, one or more accelerators, and one or more suppressing agents selected from compounds of formula I 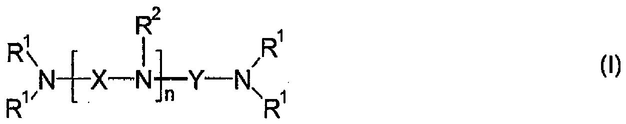 wherein
- the suppressing agent is obtainable by reacting an amine compound with a mixture of ethylene oxide and at least one compound selected from C3 and C4 alkylene oxides.
- the R¹ radicals are each independently selected from a copolymer of ethylene oxide and at least one further C3 to C4 alkylene oxide, said copolymer being a random copolymer.
- the R² radicals are each independently selected from R¹ or alkyl.
- X and Y are spacer groups independently, and X for each repeating unit independently, selected from C1 to C6 alkylen and Z-(O-Z)ₘ wherein the Z radicals are each independently selected from C2 to C6 alkylen,
- n is an integer of from 0 to 10.
- m is an integer equal to or greater than 1, particularly m = 1-10,
- the content of ethylene oxide in the copolymer of ethylene oxide and the further C3 to C4 alkylene oxide is from 30 to 70 % by weight with the substrate, and
b) applying a current density to the substrate for a time sufficient to fill the submicron size feature with copper.

2. The process according to claim 1, wherein X and Y are independently, and X for each repeating unit independently, selected from C1 to C4 alkylen.

3. The process according to anyone of the preceding claims, wherein the amine compound is selected from ethylene diamine, 1,3-diaminopropane, 1,4-diaminobutane, 1,5-diaminopentane, 1,6-diaminohexane, neopentanediamine, isophoronediamine, 4,9-dioxadecane-1,12-diamine, 4,7,10-trioxyatridecane-1,13-diamine, triethylene glycol diamine, diethylene triamine, (3-(2-aminoethyl)aminopropylamine, 3,3'-iminodi(propylamine), N,N-bis(3-aminopropyl)methylamine, bis(3-dimethylaminopropyl)amine, triethylenetetraamine and N,N'-bis(3-aminopropyl)ethylenediamine.

4. The process according to anyone of the preceding claims, wherein the C3 to C4 alkylene oxide is selected from propylene oxide.

5. The process according to anyone of the preceding claims, wherein the molecular weight M_{w} of the suppressing agent is 6000 g/mol or more.

6. The process according to claim 5, wherein the molecular weight M_{w} of the suppressing agent is from 7000 to 19000 g/mol.

7. The process according to claim 5, wherein the molecular weight M_{w} of the suppressing agent is from 9000 to 18000 g/mol.

8. The process according to anyone of the preceding claims, wherein the amine compound comprising active amino functional groups comprises of from 3 to 7 active amino groups.

9. The process according to anyone of the preceding claims, said copper plating bath further comprising one or more leveling agent.

10. The process according to anyone of the preceding claims, wherein the features have an aspect ratio of 4 or more.

## Patentansprüche

1. Verfahren zur galvanischen Abscheidung von Kupfer auf einem Substrat mit submikrometergroßen Strukturmerkmalen mit einer Aperturgröße von 30 nm oder weniger, umfassend
a) Inberührungbringen eines Kupferabscheidungsbads, umfassend eine Kupferionenquelle, einen oder mehrere Beschleuniger und ein oder mehrere Unterdrückungsmittel, das aus Verbindungen der Formel I 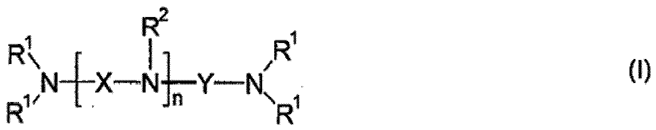 ausgewählt ist, wobei
- das Unterdrückungsmittel durch Umsetzung einer Aminverbindung mit einer Mischung von Ethylenoxid und mindestens einer aus C3- und C4-Alkylenoxiden ausgewählten Verbindung erhältlich ist,
- die Reste R¹ jeweils unabhängig aus einem Copolymer von Ethylenoxid und mindestens einem weiteren C3- bis C4-Alkylenoxid ausgewählt sind, wobei es sich bei dem Copolymer um ein statistisch aufgebautes Copolymer handelt, und
- die Reste R² jeweils unabhängig aus R¹ oder Alkyl ausgewählt sind,
- X und Y unabhängig und X für jede Wiederholungseinheit unabhängig aus C1- bis C6-Alkylen und Z-(O-Z)ₘ, wobei die Z-Reste jeweils unabhängig aus C2- bis C6-Alkylen ausgewählt sind, ausgewählte Spacergruppen sind,
- n für eine ganze Zahl von 0 bis 10 steht,
- m für eine ganze Zahl größer gleich 1 steht, insbesondere m = 1-10,
- der Ethylenoxid-Gehalt in dem Copolymer von Ethylenoxid und dem weiteren C3- bis C4-Alkylenoxid 30 bis 70 Gew.-% beträgt,
mit dem Substrat und
b) Anlegen einer Stromdichte an das Substrat über einen zum Füllen des submikrometergroßen Strukturmerkmals mit Kupfer ausreichenden Zeitraum.

2. Verfahren nach Anspruch 1, bei dem X und Y unabhängig und X für jede Wiederholungseinheit unabhängig aus C1- bis C4-Alkylen ausgewählt sind.

3. Verfahren nach einem der vorhergehenden Ansprüche, bei dem die Aminverbindung aus Ethylendiamin, 1,3-Diaminopropan, 1,4-Diaminobutan, 1,5-Diaminopentan, 1,6-Diaminohexan, Neopentandiamin, Isophorondiamin, 4,9-Dioxadecan-1,12-diamin, 4,7,10-Trioxatridecan-1,13-diamin, Triethylenglykoldiamin, Diethylentriamin, 3-(2-Aminoethyl)amino-propylamin, 3,3'-Iminodi(propylamin), N,N-Bis(3-aminopropyl)methylamin, Bis(3-dimethylaminopropyl)amin, Triethylentetraamin und N,N'-Bis(3-aminopropyl)ethylendiamin ausgewählt ist.

4. Verfahren nach einem der vorhergehenden Ansprüche, bei dem das C3- bis C4-Alkylenoxid aus Propylenoxid ausgewählt ist.

5. Verfahren nach einem der vorhergehenden Ansprüche, bei dem das Molekulargewicht M_{w} des Unterdrückungsmittels 6000 g/mol oder mehr beträgt.

6. Verfahren nach Anspruch 5, bei dem das Molekulargewicht M_{w} des Unterdrückungsmittels 7000 bis 19.000 g/mol beträgt.

7. Verfahren nach Anspruch 5, bei dem das Molekulargewicht M_{w} des Unterdrückungsmittels 9000 bis 18.000 g/mol beträgt.

8. Verfahren nach einem der vorhergehenden Ansprüche, bei dem die Aminverbindung mit aktiven aminofunktionellen Gruppen 3 bis 7 aktive Aminogruppen aufweist.

9. Verfahren nach einem der vorhergehenden Ansprüche, bei dem das Kupferabscheidungsbad ferner ein oder mehrere Einebnungsmittel umfasst.

10. Verfahren nach einem der vorhergehenden Ansprüche, bei dem die Strukturmerkmale ein Aspektverhältnis von 4 oder mehr aufweisen.

## Revendications

1. Procédé de dépôt électrolytique de cuivre sur un substrat comprenant des éléments de taille submicrométrique ayant une taille d'ouverture de 30 nanomètres ou moins, le procédé comprenant
a) la mise en contact d'un bain de cuivrage comprenant une source d'ions cuivre, un ou plusieurs accélérateurs, et un ou plusieurs agents inhibiteurs choisis parmi les composés de formule I 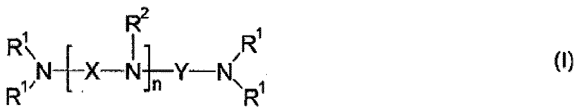 dans lequel
- l'agent inhibiteur peut être obtenu en faisant réagir un composé d'amine avec un mélange d'oxyde d'éthylène et d'au moins un composé choisi parmi les oxydes d'alkylène en C3 et C4,
- les radicaux R¹ sont chacun indépendamment choisis à partir d'un copolymère d'oxyde d'éthylène et d'au moins un autre oxyde d'alkylène en C3 à C4, ledit copolymère étant un copolymère statistique,
- les radicaux R² sont chacun indépendamment choisis à partir de R¹ ou d'un alkyle,
- X et Y sont des groupes espaceurs indépendamment, et X indépendamment pour chaque motif répétitif, choisis parmi un alkylène en C1 à C6 et Z-(O-Z)ₘ dans lequel les radicaux Z sont chacun indépendamment choisis à partir d'un alkylène en C2 à C6,
- n est un entier de 0 à 10,
- m est un entier égal ou supérieur à 1, en particulier m = 1-10,
- la teneur en oxyde d'éthylène dans le copolymère d'oxyde d'éthylène et de l'autre oxyde d'alkylène en C3 à C4 est de 30 à 70 % en poids,
avec le substrat, et
b) l'application d'une densité de courant au substrat pendant un temps suffisant pour remplir les éléments de taille submicrométrique avec du cuivre.

2. Procédé selon la revendication 1, dans lequel X et Y sont indépendamment, et X indépendamment pour chaque motif répétitif, choisis à partir d'un alkylène en C1 à C4.

3. Procédé selon l'une quelconque des revendications précédentes, dans lequel le composé d'amine est choisi parmi l'éthylènediamine, le 1,3-diaminopropane, le 1,4-diaminobutane, le 1,5-diaminopentane, le 1,6-diamino-hexane, la néopentanediamine, l'isophoronediamine, la 4,9-dioxadécane-1,12-diamine, la 4,7,10-trioxatridécane-1,13-diamine, la triéthylène-glycol-diamine, la diéthylènetriamine, la 3-(2-aminoéthyl)aminopropylamine, la 3,3'-iminodi(propylamine), la N,N-bis(3-aminopropyl)-méthylamine, la bis(3-diméthylaminopropyl)amine, la triéthylènetétramine et la N,N'-bis(3-aminopropyl)-éthylènediamine.

4. Procédé selon l'une quelconque des revendications précédentes, dans lequel l'oxyde d'alkylène en C3 à C4 est choisi à partir d'un oxyde de propylène.

5. Procédé selon l'une quelconque des revendications précédentes, dans lequel le poids moléculaire M_{w} de l'agent inhibiteur est d'au moins 6000 g/mol.

6. Procédé selon la revendication 5, dans lequel le poids moléculaire M_{w} de l'agent inhibiteur est de 7000 à 19 000 g/mol.

7. Procédé selon la revendication 5, dans lequel le poids moléculaire M_{w} de l'agent inhibiteur est de 9000 à 18 000 g/mol.

8. Procédé selon l'une quelconque des revendications précédentes, dans lequel le composé d'amine comprenant des groupes aminofonctionnels actifs comprend de 3 à 7 groupes amino actifs.

9. Procédé selon l'une quelconque des revendications précédentes, ledit bain de cuivrage comprenant en outre un ou plusieurs agents nivelants.

10. Procédé selon l'une quelconque des revendications précédentes, dans lequel les éléments ont un rapport de forme d'au moins 4.
